# EUROPEAN PATENT APPLICATION

(11) **EP 2 911 209 A1**
(43) Date of publication of application: **26.08.2015**
(21) Application number: 15156165.1
(22) Date of filing: 23.02.2015
(51) Int. Cl.: H01L 33/64, H01L 25/075

(54) **Light emitting diode package structures**

(30) Priority: 21.02.2014 CN 201420075500 U; 29.05.2014 US 201462004622 P
(71) Applicant: Luminus Devices, Inc., Woburn, MA 01801 (US)
(72) Inventor: Cai, Pei-Song, Woburn, MA Massachusetts 01801 (US); Shi, Junpeng, Woburn, MA Massachusetts 01801 (US); Liang, Xinghua, Woburn, MA Massachusetts 01801 (US); Guan, Jeff, Woburn, MA Massachusetts 01801 (US); Xu, Chen-Ke, Woburn, MA Massachusetts 01801 (US)
(74) Representative: Hoffmann Eitle

(57) **Abstract**

A light emitting diode package, comprising: a substrate including an upper surface and a lower surface, the substrate comprising a metal block and an electrically insulating region surrounding, at least in part, the metal block; and a light emitting diode chip mounted on the substrate, the light emitting diode chip in electrical communication with the metal block; and an encapsulant covering at least an upper surface of the light emitting diode chip.

## Description

### RELATED APPLICATIONS

This application claims priority to Chinese Utility Model Application Serial No. 201420075500.7 which was filed on February 21, 2014 and to U.S. Provisional Patent Application Serial No. 62/004622 which was filed on May 29, 2014, both of which are incorporated herein by reference in their entireties.

### TECHNICAL FIELD

This application relates to a packaging structure, particularly to a light emitting diode package structure.

### BACKGROUND

A light-emitting diode (LED) is a light-emitting device that often can produce light in a more efficient manner than other light-emitting devices, such as incandescent light sources and/or fluorescent light sources. The relatively high power operation and efficiency associated with LEDs has created an interest in using LEDs to displace conventional light sources in a variety of lighting applications. For example, in some instances, LEDs are being used as traffic lights and to illuminate cell phone keypads and displays.

Typically, an LED chip is formed of multiple layers, with at least some of the layers being formed of different materials. Generally, the layers on one side of the junction where a quantum well is grown are doped with donor atoms that result in high electron concentration (such layers are commonly referred to as n-type layers), and the layers on the opposite side are doped with acceptor atoms that result in a relatively high hole concentration (such layers are commonly referred to as p-type layers). During use, electrical energy is usually injected into an LED and then converted into electromagnetic radiation (light), some of which is extracted from the LED, for example, via an emission surface.

LED chips may be mounted on a substrate in a packaging structure. In general, there is a need to provide improved packaging structures which enhance LED performance.

### SUMMARY OF INVENTION

Light emitting diode package structures are described herein.

In one aspect, a light emitting diode package is provided. The package includes a substrate including an upper surface and a lower surface. The substrate comprises a metal block and an electrically insulating region surrounding, at least in part, the metal block. The package further comprises a light emitting diode chip mounted on the substrate. The light emitting diode chip is in electrical communication with the metal block. The package further comprises an encapsulant covering at least an upper surface of the light emitting diode chip.

In some embodiments, the light emitting diode chip may be mounted directly on the metal block. In some embodiments, the substrate further comprises a second metal block and the electrically insulating region surrounds, at least in part, the second metal block. The package may further comprise a second light emitting diode chip mounted on the substrate. The second light emitting diode chip may be in electrical communication with the second metal block. The second light emitting diode chip may be mounted directly on the second metal block. In some cases, the two metal blocks have axial symmetry.

In some embodiments, the metal block includes a portion that extends to an edge of the substrate. The metal block may include a portion that extends to more than one edge of the substrate.

In some embodiments, the metal block includes a first portion having a first shape and a second portion having a second shape. In some cases, the first portion is located above the second portion. The second portion may extend to an edge of the substrate.

In another aspect, the light emitting diode package comprises: a substrate having a positive and negative two flat surfaces, and at least two metal blocks and an insulating portion. The metal blocks are embedded in the insulating portion. The light emitting diode chip is located on a metal block, and wherein at least two of the metal block is electrically connected. Plastic packaging covers the surface of the LED chip and at least part of the substrate. The metal block has a projecting connecting portion, which extends to the edge of the substrate.

In some embodiments, the substrate has two metal blocks, for both electrical and heat dissipation. In some cases, the metal blocks comprise at least three projecting portions. In some embodiments, the two metal blocks have axial symmetry.

In some embodiments, the metal block has at least one projecting portion connected to the inclined angle of the metal block. In some embodiments, the two metal blocks are rotated 180 ° symmetry.

In some embodiments, the electrically insulating region between the metal block is "I" shaped.

In some embodiments, the electrically insulating region is between respective S-shaped pieces of metal or anti-S-shaped pieces of metal.

In some embodiments, in the substrate, the vertical direction of the metal block is divided into upper and lower portions, wherein an upper portion and a lower portion of said substrate have different shapes. In some embodiments, some parts of the upper portion laterally project relative to the lower portion and some parts of the lower portion of the metal block certain parts of the upper lateral projection. In some embodiments, the upper portion and/or lower portion of the metal block includes a projecting connecting portion.

In some embodiments, the thickness of the encapsulation (e.g., plastic encapsulation) is between 0.2 ∼ 5mm. In some embodiments, the thickness of the encapsulation is between 0.2 ∼ 3mm.

In some embodiments, the light emitting diode package further comprises a wavelength conversion material (e.g., a phosphor), The wavelength conversion material may be directly incorporated in the plastic packaging directly at the surface of the light emitting diode chip / package plastic surface.

Embodiments described herein may have at least the following beneficial effects: 1) the heat conductivity through the metal block(s) may effectively improve thermal performance of the package body; 2) due to the surface of the substrate plane not needing brackets (such as bowls cups) and sidewalls that may block light, the packages enables a broader emitting angle and enhanced efficiency; 3) the design may use less material resulting in lower costs.

The light emitting diode packages described herein can be applied to a variety of display systems, lighting systems, taillights and other fields.

The utility of other novel features and advantages will be set forth in the description which follows, and in part will be obvious from the description, or by understanding the embodiments of the application. The objectives and other advantages of the new utility through the specification, the drawings, and particularly pointed out in the structure to be realized and attained claims.

### BRIEF DESCRIPTION OF DRAWINGS

Figure 1 is a sectional view of a light emitting diode package according to an embodiment.
Figure 2 shows a front side of the substrate of the light emitting diode package of Figure 1 according to an embodiment.
Figure 3 shows a back side of the substrate of a light emitting diode according to an embodiment.
Figure 4 shows a variation of the back side of the substrate of a light emitting diode according to an embodiment.
Figure 5 shows a variation of the back side of the substrate of a light emitting diode according to an embodiment.
Figure 6 is a sectional view of a light emitting diode package according to an embodiment.
Figures 7 - 8 show two variants of respective light emitting diode packages according to embodiments.

### DETAILED DESCRIPTION

Light emitting diode package structures are described herein.

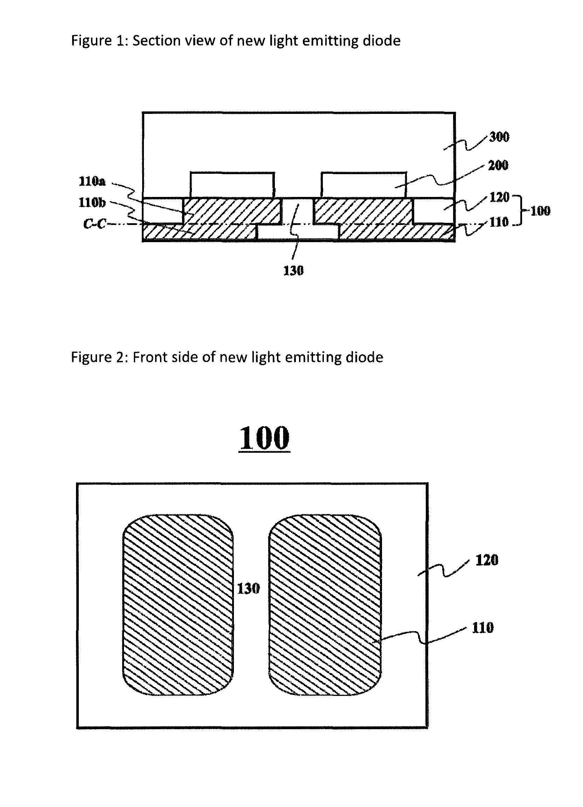

Referring to Figure 1, a light emitting diode package comprises a substrate 100, a light emitting diode chip 200 and an encapsulant 300. The substrate may include two opposed surfaces (e.g., a positive surface and a negative surface). In the illustrative embodiment, the substrate includes two metal blocks 110. In other embodiments, the substrate may include a single metal block or more than two metal blocks. The metal block(s) are surrounded, at least in part, by an insulating portion 110. For instance, the metal block(s) may be embedded, at least in part, in the insulating portion. Light emitting diode chip 200 may be in electrical and/or thermal connection with a metal block. For instance, the light emitting diode chip may be mounted on the metal block. In some cases, a conductive material may be provided between the light emitting diode chip and the metal block to facilitate mounting. In embodiments with more than one metal block, respective light emitting diode chips may be in electrical and/or thermal connection with (e.g., mounted on) each metal block. In the illustrative embodiment, a portion 120 exposes a section of the surface of the metal block(s). In some embodiments, portion 120 may be an air gap. It should be understood that portion 120 is not present in all embodiments of the invention. In the illustrative embodiment, encapsulant 300 covers the surface of the light emitting diode chip 200 and covers at least part of the substrate.

The insulating portion may comprise any suitable insulating material known in the art. In some embodiments, the insulating material comprises a plastic, e.g., a thermoplastic (such as PPA, PCT, CP, etc.) or a thermosetting plastic (e.g., EMC, SMC, Polyester, etc.). Other insulating material may also be used.

In some embodiments, the two light emitting diode chips may be electrically connected to one another. The two chips may be connected in series or parallel.

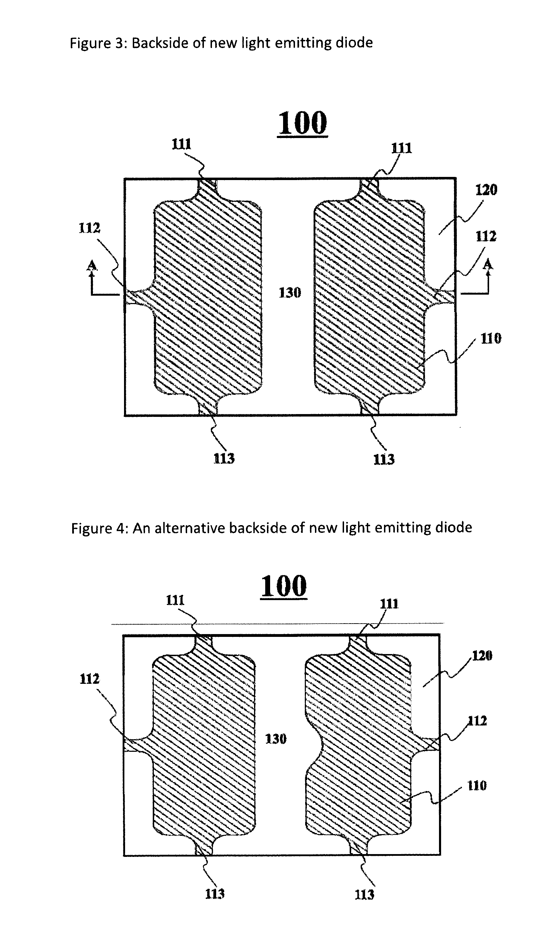

Referring again to Figure 1, with reference plane C as the boundary, the metal block 110 may be divided into upper and lower portions 110a, 110b in the vertical direction. In the illustrative embodiment, the shapes of the upper and lower portions are not the same. In other embodiments, the shape of the upper and lower portions may be the same. In some cases, in the area close to the electrically insulating region 130, the upper portion of the metal block may laterally project relative to the lower portion. In some cases, in a region near the edge of the substrate, the lower part of the upper metal block may laterally project relative to the upper portion, so the metal block 110 and the insulating portion 120 in the vertical form the snap direction. Referring to Figure 3, the metal block has three protruding portions 111, 112 and 113, which extend to the edge(s) of the substrate. As shown the protruding portions project in the lower metal block portion. However, in some embodiments, the protruding portions that extend to the edge(s) of the substrate may be located in the upper portion of the metal block.

The encapsulant may be any suitable encapsulation material known in the art including plastic and/or epoxy materials. In some embodiments, the encapsulant may contain a wavelength converting material (e.g,. phosphor). The thickness of the encapsulant may be between 0.2 ∼ 5mm.

In some embodiments, the two metal blocks may be axially symmetric. The electrically insulating region may be "I"-shaped.

In some embodiments, the substrate (via metal block) has a positive surface on one side and a negative surface on the opposite side. For example, the positive side can function as an anode and the negative side can function as a cathode. The metal blocks may be electrically connected to suitable voltage source(s).

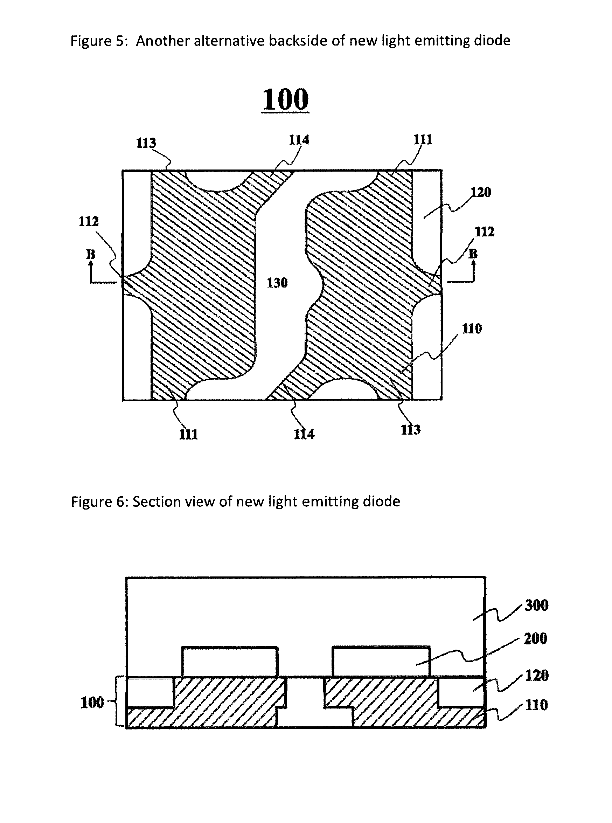

Figures 5 and 6 show another light emitting diode package.

Referring to Figure 5, the electrically insulating region is S-shaped (or anti-S-) and each of the metal connecting block has four protruding portions 111, 112, 113, 114.

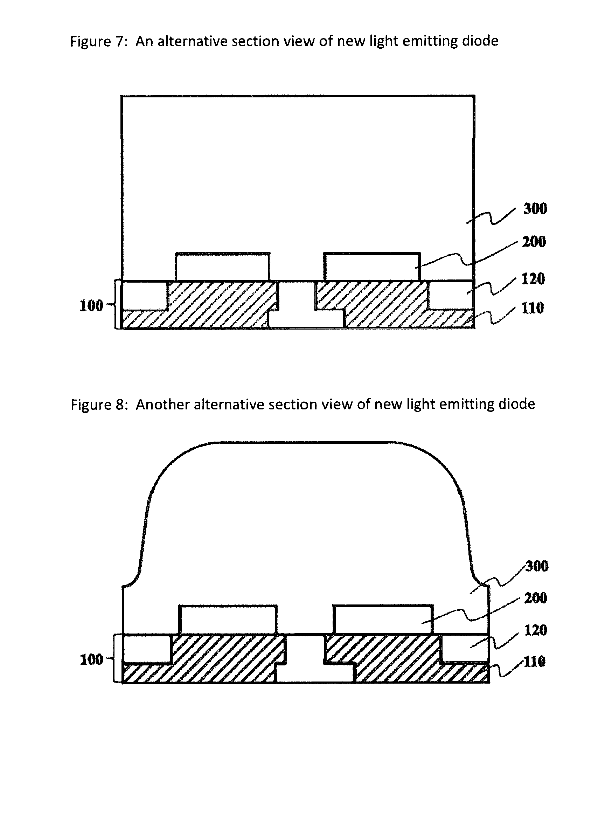

Referring to Figure 7, the thickness of the package can be increased to expand the angle for light emission. For example, the package may have a thickness of 0.5 ∼ 5mm and, in some cases, 2 ∼ 5mm.

Figure 8 shows another embodiment which further expands the angle for light emission from the package body. As shown, the packaging includes a curved side 300.

## Claims

1. A light emitting diode package, comprising:
a substrate including an upper surface and a lower surface, the substrate comprising a metal block and an electrically insulating region surrounding, at least in part, the metal block; and
a light emitting diode chip mounted on the substrate, the light emitting diode chip in electrical communication with the metal block; and
an encapsulant covering at least an upper surface of the light emitting diode chip.

2. The light emitting diode package according to any preceding claim, wherein the substrate further comprises a second metal block and the electrically insulating region surrounds, at least in part, the second metal block.

3. The light emitting diode package according to any preceding claim, further comprising a second light emitting diode chip mounted on the substrate, the second light emitting diode chip in electrical communication with the second metal block.

4. The light emitting diode package according to any preceding claim, wherein:
the light emitting diode chip is mounted directly on the metal block; and/or
the second light emitting diode chip is mounted directly on the second metal block.

5. The light emitting diode package according to any preceding claim, wherein the metal block includes a portion that extends to an edge of the substrate.

6. The light emitting diode package according to any preceding claim, wherein the metal block includes a first portion having a first shape and a second portion having a second shape.

7. The light emitting diode package according to any preceding claim, wherein the first portion is located above the second portion.

8. The light emitting diode package according to any preceding claim, wherein the second portion extends to an edge of the substrate.

9. The light emitting diode package according to any preceding claim, wherein the metal block includes a portion that extends to more than one edge of the substrate.

10. A light emitting diode package, comprising:
a substrate having opposed two flat surfaces and including at least two metal blocks and an electrically insulating portion, wherein the metal blocks are surrounded, at least in part, by the electrically insulating portion, wherein the metal blocks include a projection portion which extends to an edge of the substrate;
light emitting diode chips electrically connected to the metal blocks; and plastic packaging covering the upper surface of the light emitting diode chips and a portion of the substrate.

11. The light emitting diode package according to any preceding claim, wherein the two metal blocks have axial symmetry.

12. The light emitting diode package according to claim 12, wherein:
the two metal blocks are 180 ° out of rotational symmetry; or
the electrically insulating portion is I-shaped; or
the electrically insulating portion is S-shaped.

13. The light emitting diode package according to any preceding claim, wherein:
said metal block has at least one projecting portion connected to an inclined angle of the metal block; and/or
each of the metal blocks comprises at least three projecting portions.

14. The light emitting diode package according to any preceding claim, wherein the two metal blocks are configured to provide for both electrical and thermal dissipation.

15. The light emitting diode package according to any preceding claim, wherein the vertical direction of the metal blocks are divided into upper and lower portions, wherein the upper part and the lower part are not the same shape.
